# EUROPEAN PATENT APPLICATION

(11) **EP 4 622 401 A1**
(43) Date of publication of application: **24.09.2025**
(21) Application number: 25163152.9
(22) Date of filing: 12.03.2025
(51) Int. Cl.: H05K 1/02, H05K 3/00, H05K 3/04, H05K 3/06

(54) **A SURFACE MOUNT TECHNOLOGY (SMT) PANEL FRAME**

(30) Priority: 22.03.2024 IN 202421022254
(71) Applicant: Hella India Automotive Pvt Ltd., 411057 Pune (IN)
(72) Inventor: Eswaran, Palaniraj, 625520 Tamilnadu (IN)
(74) Representative: Behr-Wenning, Gregor

(57) **Abstract**

The present invention provides a Surface Mount Technology (SMT) panel frame. The SMT panel frame (100) includes a panel (110) and atleast one copper material region (130) arranged on the panel (110). The panel (110) is substantially enough to securely hold atleast one printed circuit board (120), the panel (110) being removably arranged around the printed circuit board (120), wherein a predefined region on the printed circuit board (PCB) (120) is designated for the placement of Data Matrix Codes (DMC), fiducials and test points. The atleast one copper material region (130) selectively arranged within the panel (110) based on the placement of Data Matrix Codes, fiducials, and test points, such that the copper material regions align with the position and placement of panel fiducials, DMC and the test points thereby reducing the requirement of copper throughout the panel (110).

## Description

### Field of the invention

The present invention relates to a panel for printed circuit boards. Specifically, the present invention relates to an SMT panel frame for printed circuit boards and a method for optimizing copper material on an SMT panel frame used in printed circuit board (PCB) manufacturing.

### Background of the invention:

Copper is an important component in making circuit boards because it helps with sending signals and managing heat. When circuit boards are being made, especially small ones, they often group together on panels to make things more efficient and consistent. These panels, known as SMT/shipping panels, hold several small circuit boards at once. This grouping helps manufacturers put electronic parts on each board at the same time, making the whole process faster and more efficient. Shipping panels or SMT panels are larger structures or boards used for the secure transportation of multiple individual PCBs. These panels are designed to hold atleast one or multiple PCBs in a fixed arrangement, allowing for efficient handling, packaging, and movement of the PCBs through various stages of the manufacturing process.

These SMT/shipping panels are like puzzle pieces that connect to larger panels, often called mother panels, made by big PCB manufacturers. However, after reaching their destination, individual PCBs are typically separated from the shipping panel or mother panel through a de-paneling process. The de-paneling method could involve techniques such as milling, punching, or other methods, depending on the design and requirements of the PCBs.

The depaneling method involves cutting or milling along predefined lines or paths to separate the individual PCBs. This process not only separates the boards but also trims away any excess material, including copper, from the edges or breakaway areas. Since, copper is used across the entire panel, all the excess copper will be trimmed away from the panel.

In such approaches, copper, being a valuable yet costly resource, was utilized extensively without strategic considerations. This practice has been associated with several drawbacks, leading to inefficiencies and increased production costs. Firstly, the use of copper material throughout the entire panel results in inefficiencies within the manufacturing process. Since copper is a significant cost component in PCB production, using it excessively without specific purpose or strategic placement contributes to higher material costs.

Additionally, the use of copper across the entire panel leads to unnecessary wastage of resources because of removal of excess copper at the time of de panelling. As copper is a finite and valuable material, its inefficient use not only increases production costs but also contributes to environmental concerns.

The necessity for customization and optimization within the context of Surface Mount Technology (SMT) panel frames becomes apparent as a response to the challenges posed by conventional practices.

Therefore, there is a requirement for an arrangement to optimize copper material in a Surface Mount Technology (SMT) panel frame which can completely or partially overcome the drawbacks associated with the prior art solutions.

### Objects of the invention

An object of the present invention is to provide an arrangement to optimize copper material in a Surface Mount Technology (SMT) panel frame to minimize wastage of copper, ensuring the copper material is placed according to the requirement, leading to cost savings and resource efficiency.

Another object of the present invention is to selectively arrange copper material based on the placement of Data Matrix Codes (DMC), fiducials and test points on the PCB contributing to a more efficient use of resources.

Yet another object of the present invention is the optimized and targeted use of copper material on the panel which can result in a reduction in production costs, enhancing cost-effectiveness for PCB manufacturers by minimizing unnecessary material expenses.

One more object of the present invention is to reduce copper wastages contributing environmental conservation by conserving valuable resources and decreasing the environmental impact associated with unnecessary material usage.

Still an object of the present invention is to provide an SMT panel frame where the manufacturers can customize the arrangement of copper material based on the unique requirements of each PCB design, providing flexibility and adaptability in the manufacturing process.

### Summary of the invention:

According to the present invention, an SMT panel frame for Printed Circuit Board is provided. The SMT panel frame includes a panel and atleast one copper material region on the panel. The panel is substantially enough to securely hold atleast one printed circuit board. The panel is removably arranged around the printed circuit board, wherein a predefined region on the printed circuit board (PCB) is designated for the placement of Data Matrix Codes (DMC), fiducials and test points.

The atleast one copper material region is selectively arranged within the panel based on the placement of Data Matrix Codes, fiducials, and test points, such that the copper material regions align with the position and placement of panel fiducials, DMC and the test points thereby reducing the requirement of copper throughout the panel.

In an aspect, the at least one copper material region may include a conductive layer selectively arranged within the panel facilitating conductivity for electrical components on the printed circuit board.

In an aspect, the at least one copper material region is selectively etched or deposited onto the panel, after selectively removing copper material from the breakaway area through etching process after the lamination process or by cutting process before the lamination process of the SMT panel frame providing a customizable configuration based on the position and placement of Data Matrix Codes, fiducials and test points.

In an aspect, the placement of the at least one copper material region is determined based on the dimensions and form factors of the printed circuit board.

In an aspect, the at least one copper material region is configured to minimize the utilization of copper material on the panel surface.

Further, in an aspect, a method for optimizing copper material on an SMT panel frame used in printed circuit board (PCB) manufacturing is provided. The method begins with **providing an SMT panel frame with a breakaway area on the panel, wherein copper material is selectively excluded, except in regions containing DMC, Fiducials, and test points. Further, a copper removal process is implemented in the breakaway area of the SMT panel frame.**

**The copper material from the breakaway area can be removed through an etching process after the lamination of the SMT panel frame or by cutting before the lamination process of the SMT panel frame.**

**Removing copper material from the breakaway area through an etching process after the lamination of the SMT panel frame begins with providing a panel with breakaway area to securely hold at least one printed circuit board (PCB). Then removably arranging the panel around the printed circuit board. Further, selectively** removing unwanted copper material from the breakaway area **and retaining at least one copper material region within the** breakaway area of the **panel based on the placement of Data Matrix Codes (DMC), fiducials, and test points on the printed circuit boards. Customizing and aligning the arrangement of the at least one copper material region through selective etching or deposition onto the breakaway area of the panel, providing a flexible configuration based on the position and placement of Data Matrix Codes, fiducials, and test points on the printed circuit board thereby facilitating conductivity for electrical components on the printed circuit board. Finally, configuring the at** least one copper material region to minimize the utilization of copper material on the panel surface.

In an aspect, **the etching process comprises selectively removing copper material from the breakaway area through chemical etching after the lamination process.**

**In an aspect, removing copper material from the breakaway area by cutting before the lamination process of the SMT panel frame begins with implementing a cutting process on a copper base plate before lamination process to remove unnecessary copper and ensuring the remaining copper is sufficient for the lamination process on** a **PCB core material or prepreg. Then retaining a defined amount of copper material on four corners of the copper base plate for pre-positioning the copper sheet before lamination, and for the placement of DMC, fiducials, test points, etc.. Finally, ensuring the necessary copper material is connected and not isolated, to facilitate lamination process.**

In an aspect, the cutting before lamination process comprises removing excess copper material from the breakaway area through a cutting process before the lamination of the SMT panel frame.

### Brief description of drawings:

The advantages and features of the present invention will be understood better with reference to the following detailed description and claims taken in conjunction with the accompanying drawings, wherein like elements are identified with like symbols, and in which:
Figure 1 shows a schematic representation of an SMT panel frame in accordance with the present invention;
Figure 2 shows a schematic representation of a mother panel/larger panel where a plurality of SMT panel frames are connected;
Figure 3 shows an exploded view of the SMT panel frame; and
Figure 4a and 4b shows a **cutting process implemented on a copper base plate before lamination process;**
Figure 5 illustrates an SMT panel frame on a base plate with cutting process implemented thereon;
Figure 6 shows a flow chart illustrating a method for optimizing copper material on an SMT panel frame used in printed circuit board (PCB) manufacturing in accordance with the present invention;
Figure 7 shows a flow chart illustrating a method of removing copper material from the breakaway area through an etching process after the lamination of the SMT panel frame in accordance with the present invention; and
Figure 8 shows a flow chart illustrating a method for **removing copper material from the breakaway area by cutting before the lamination process of the SMT panel frame** in accordance with the present invention.

### Detailed description of the invention

An embodiment of this invention, illustrating its features, will now be described in detail. The words "comprising," "having," "containing," and "including," and other forms thereof, are intended to be equivalent in meaning and be open-ended in that an item or items following any one of these words is not meant to be an exhaustive listing of such item or items, or meant to be limited to only the listed item or items.

The terms "first," "second," and the like, herein do not denote any order, quantity, or importance, but rather are used to distinguish one element from another, and the terms "a" and "an" herein do not denote a limitation of quantity, but rather denote the presence of at least one of the referenced item.

The present invention relates to an arrangement for optimizing copper material in a Surface Mount Technology (SMT) panel frame to minimize wastage of copper, ensuring that the copper material is strategically placed where it is needed, leading to cost savings and resource efficiency. By implementing the method, the manufacturers can customize the arrangement of copper material based on the unique requirements of each PCB design, providing flexibility and adaptability in the manufacturing process.

The disclosed embodiments are merely exemplary of the invention, which may be embodied in various forms.

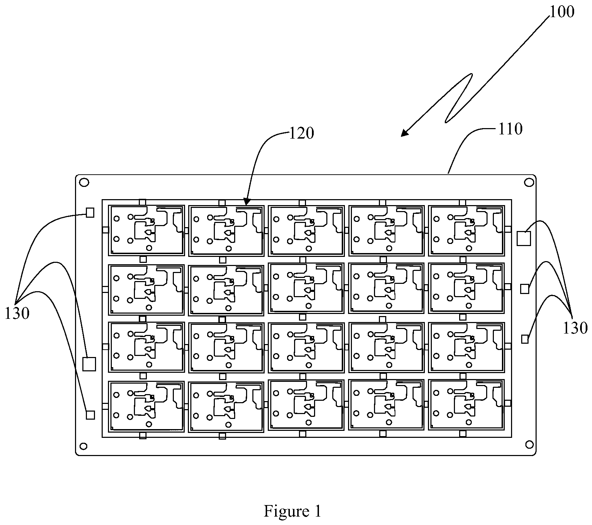

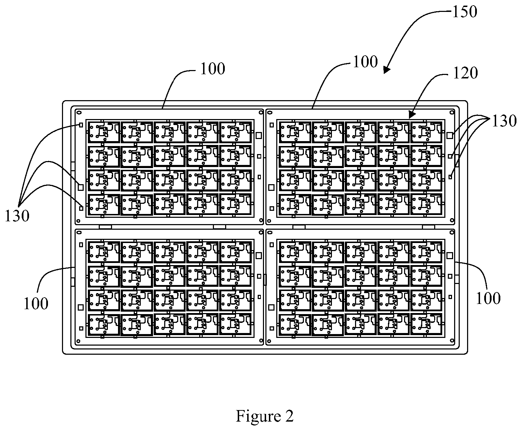

Referring now to figure 1, an SMT panel frame (100) in accordance with the present invention is illustrated. The SMT panel frame (100) is a shipping panel to contain and transport multiple individual PCBs. The SMT panel is to streamline the handling, packaging, and transportation of multiple PCBs throughout various phases of production, including manufacturing, assembly, testing, and shipping to end-users. The SMT panel protects against physical damage, electrostatic discharge (ESD), and other potential risks associated with transportation. Multiple SMT panels can be connected to larger panels/mother panel (150) as shown in figure 2.

The SMT panel frame (100) includes a panel (110) with a breakaway area and at least one copper material region (130) on the breakaway area of the panel (110). The panel (110) is substantially enough to securely hold at least one printed circuit board (PCB) (120) therewithin. The panel (110) is a generally rectangular panel which is removably arranged around a printed circuit board (120) or a plurality of printed circuit boards. The breakaway area of the panel refers to a section of the SMT panel frame that is designed to be separated or broken away from the frame easily.

A predefined region on the PCB is designated for the placement of Data Matrix Codes (DMC), fiducials, and test points. The Data Matrix Code (DMC) is a two-dimensional barcode that stores information in a matrix of black and white cells. It is used for encoding data such as part numbers, serial numbers, or other identification details. In the present embodiment, there are specific areas on the printed circuit board (PCB) (120) designated for the placement of Data Matrix Codes. These DMC codes are located for traceability and identification purposes during the manufacturing and assembly processes.

Fiducials are reference points or markers placed on the PCB. The fiducials are placed on the PCB to assist in the precise alignment of components during the assembly process. Further, the test points are specific locations on the PCB designed for electrical testing purposes. These points provide access to different nodes or signals on the circuit for testing and troubleshooting. The test points are located on the PCB to facilitate testing during various stages of production.

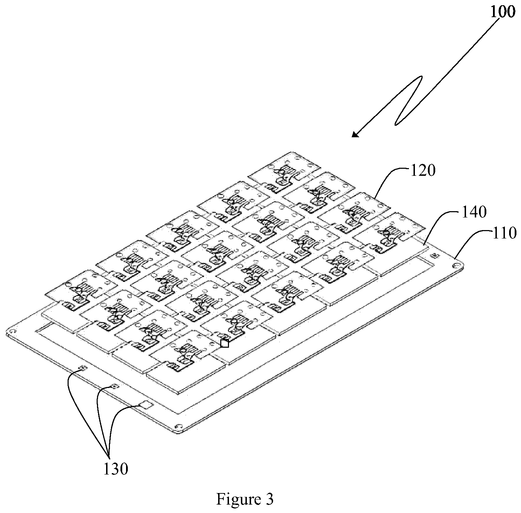

Referring to figure 3, the PCB (120) is mounted on a core material/prepreg (140) which is a solid dielectric (insulating) material that provides mechanical support to the board. The core material (140) may be an FR4 (Flame Retardant 4)/IMS base plate. It may be obvious to a person skilled in the art to use any suitable core material according to the PCB requirement.

In the present embodiment, the at least one copper material region (130) is selectively arranged within the panel (110) based on the placement of DMC, fiducials, and test points on the PCB (120). Referring to the figure 1, 2 and 3, 6 copper material regions are arranged within the panel (110). It may be obvious to a person skilled in the art to arrange two or more copper material regions to be selectively arranged within the panel (110) based on the placement of DMC, fiducials, and test points on the PCB. The **copper material regions align with the position and placement of panel fiducials, DMC and the test points to reduce the requirement of copper throughout the panel (110).**

In the present embodiment, the at least one copper material region (130) may include a conductive layer. The conductive layer is selectively arranged within the panel (110) is to facilitate conductivity for electrical components on the printed circuit board (120). The arrangement of the conductive layer aligns with features on the PCB to enhance the electrical performance.

In an embodiment, the at least one copper material region (130) can be selectively etched or deposited onto the panel (110) after selectively removing copper material from the breakaway area of the panel (110) through etching process after the lamination process or by cutting process before the lamination process of the SMT panel frame (100).

In an embodiment, the copper material from the breakaway area of the panel (110) is removed through etching process after the lamination process. Specifically, unwanted copper material which covers the breakaway area of the panel (110) is selectively removed from the breakaway area **and retains at least one copper material region within the** breakaway area of the **panel (110) based on the placement of Data Matrix Codes (DMC), fiducials, and test points on the printed circuit boards thereby** optimizing copper material on the SMT panel frame (100). This allows for a customizable configuration based on the specific position and placement of DMC, fiducials, and test points on the PCB.

In an embodiment, the placement of the at least one copper material region (130) is determined based on the dimensions and form factors of the printed circuit board (120).

Further, the at least one copper material region (130) is specifically configured to minimize the utilization of copper material on the panel surface. This configuration helps in reducing copper waste during the PCB assembling/manufacturing process.

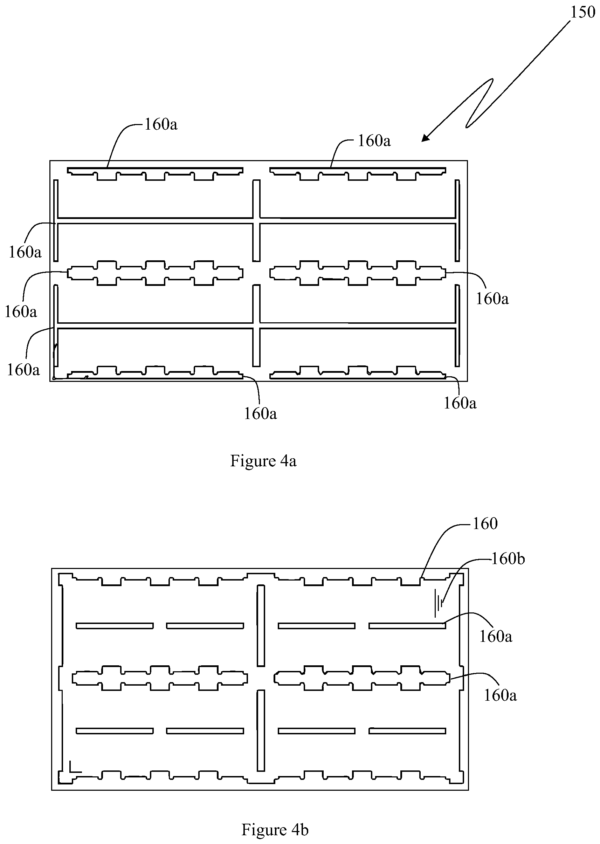

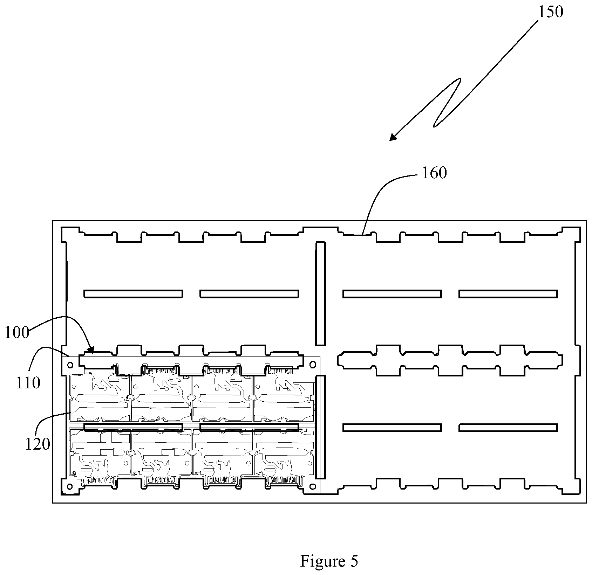

**In** an embodiment**, the copper material which covers the breakaway area panel (110) of the SMT panel frame (100) is removed by cutting before the lamination process of the SMT panel frame (100). In such embodiment, a cutting process is implemented on a copper base plate (160) before lamination process to remove unnecessary copper regions (160a) as shown in** **figure 4a** **and** ensures the remaining copper (160b) is sufficient for the lamination process on a PCB core material or prepreg as shown in figure 4b. Further, a **defined amount of copper material is retained on four corners of the copper base plate (160) for pre-positioning the copper sheet before lamination, and for the placement of DMC, fiducials, test points, etc as shown in** **figure 5****. In such embodiment, the necessary copper material has to be connected and not isolated to facilitate the lamination process.**

Specifically, following transportation of the SMT panel frame, individual PCBs are separated from the SMT panel through a de-paneling process. Various methods, such as milling or punching, may be employed depending on the specific design and requirements. During the de-paneling process, since the copper material is arranged or integrated only on the designated copper material region, there is no requirement of trimming of excess copper materials from the panel (110). Hence, minimizes the copper material wastage, contributing to an overall more efficient and resource-conscious manufacturing procedure of PCB panels.

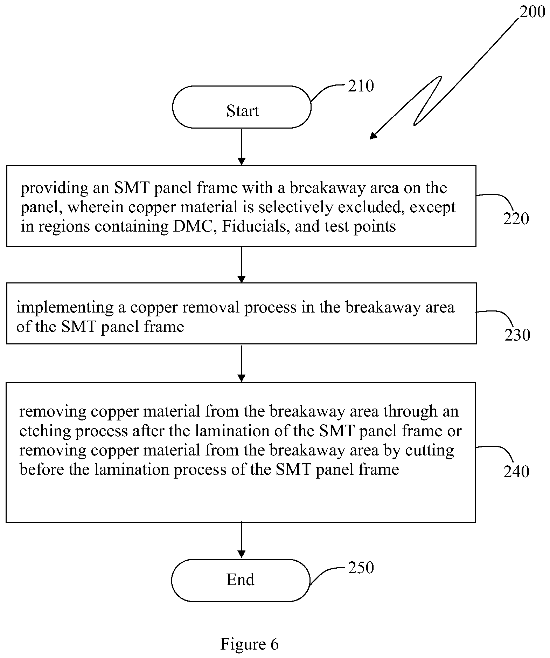

Referring now to figure 6, a method (200) for optimizing copper material on an SMT panel frame used in printed circuit board (PCB) manufacturing in accordance with the present invention is provided. For the sake of brevity, the method (200) is described in conjunction with the above described SMT panel frame.

The method (200) starts at step 210.

At step 220, **an SMT panel frame with a breakaway area on the panel is provided. The SMT panel frame is to securely hold at least one printed circuit board (PCB). In the SMT panel frame, copper material is selectively excluded, except in regions containing DMC, Fiducials, and test points.**

**At** step **230, a copper removal process is implemented to remove copper material from the breakaway area of the SMT panel frame.**

At step **240, copper material is removed from the breakaway area through an etching process after the lamination of the SMT panel frame or the copper material is removed from the breakaway area by cutting before the lamination process of the SMT panel frame.**

**The** method **ends at step 250.**

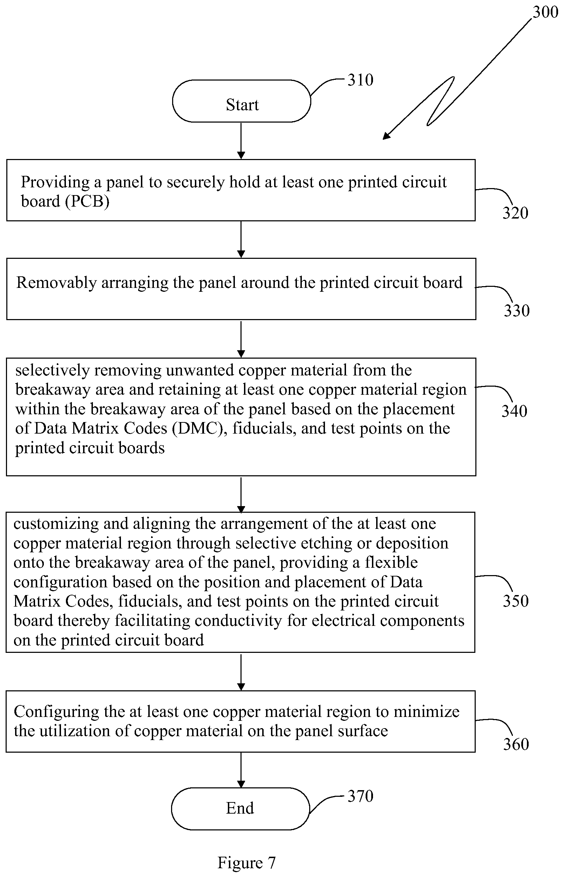

**Referring** now to figure 7, a method of **removing copper material from the breakaway area through an etching process after the lamination of the SMT panel frame in accordance with the present invention is illustrated.**

The method starts at step 310.

At step 320, **the panel with breakaway area to securely hold at least one printed circuit board (PCB) is provided.**

At step 330, the panel is removably arranged around the printed circuit board.

Further at step 340, **implementing an etching process on a copper base plate arranged on the SMT panel frame.** The etching process includes selectively removing copper material from the breakaway area through chemical etching after the lamination process. While doing the etching process, only the unwanted copper material is removed whereas at least one copper material region is selectively retained within the panel based on the placement of Data Matrix Codes (DMC), fiducials, and test points on the printed circuit boards.

At step 350, the at least one copper material region is customized and aligned through selective etching or deposition onto the panel to provide a flexible configuration based on the position and placement of Data Matrix Codes, fiducials, and test points on the printed circuit board thereby facilitate conductivity for electrical components on the printed circuit board.

At step 360, the at least one copper material region is configured on the panel to minimize the utilization of copper material on the panel surface.

The method ends at step 370.

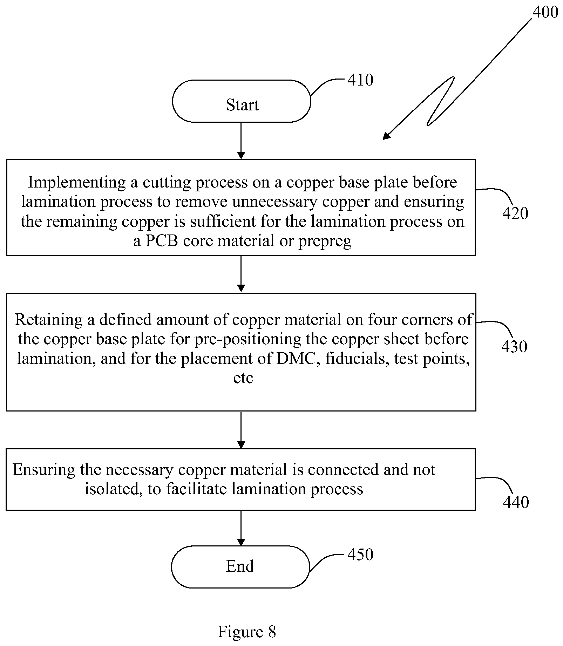

In another embodiment, a method (400) for **removing copper material from the breakaway area by cutting before the lamination process of the SMT panel frame** in accordance with the present invention is illustrated in figure 8.

The lamination process includes covering the printed circuit board (PCB) with a layer, composed of materials like the core material/prepreg and copper foil where multiple layers are bonded together to create a composite structure. The removal of excess copper before lamination ensures that only the copper regions arranged on the SMT panel frame contribute to the electrical connectivity and functionality of the SMT Panel Frame.

The method starts at step 410.

At step 420, a cutting process is implemented on a copper base plate before the lamination process to remove unnecessary copper.

At step 430, a defined amount of copper material is retained on the four corners of the base plate for pre-positioning the copper sheet before lamination to help in the placement of elements such as DMC, fiducials, and test points.

At step 440, it is ensured that the necessary copper material remains is connected and is not isolated. Finally, the removed copper in its pure form is used for recycling or repurposing.

The method ends at step 450.

Therefore, the present invention provides an advantage of providing an arrangement to optimize copper material in a Surface Mount Technology (SMT) panel frame. The arrangement minimizes the wastage of copper, ensuring the copper material is placed according to the requirement, leading to cost savings and resource efficiency. Further, the optimized and targeted use of copper material on the panel results in a reduction in production costs, enhancing cost-effectiveness for PCB manufacturers by minimizing unnecessary material expenses. The specific arrangement reduces copper wastages contributing environmental conservation by conserving valuable resources and decreasing the environmental impact associated with unnecessary material usage. Further, the arrangement helps the manufacturers to customize the arrangement of copper material based on the unique requirements of each PCB design, providing flexibility and adaptability in the manufacturing process.

The foregoing descriptions of specific embodiments of the present invention have been presented for purposes of illustration and description. They are not intended to be exhaustive or to limit the present invention to the precise forms disclosed, and obviously, many modifications and variations are possible in light of the above teaching. The embodiments were chosen and described in order to explain the principles of the present invention best and its practical application, to thereby enable others skilled in the art to best utilise the present invention and various embodiments with various modifications as are suited to the particular use contemplated. It is understood that various omission and substitutions of equivalents are contemplated as circumstance may suggest or render expedient, but such are intended to cover the application or implementation without departing from the scope of the claims of the present invention.

## Claims

1. A Surface Mount Technology (SMT) panel frame (100) comprising:
a panel (110) substantially enough to securely hold atleast one printed circuit board (120), the panel (110) being removably arranged around the printed circuit board (120), wherein a predefined region on the printed circuit board (PCB) (120) is designated for the placement of Data Matrix Codes (DMC), fiducials and test points;
atleast one copper material region (130) selectively arranged within the panel (110) based on the placement of Data Matrix Codes, fiducials, and test points, such that the copper material regions align with the position and placement of panel fiducials, DMC and the test points thereby reducing the requirement of copper throughout the panel (110).

2. The SMT panel frame (100) as claimed in claim 1, wherein the at least one copper material region (130) includes a conductive layer selectively arranged within the panel (110) facilitating conductivity for electrical components on the printed circuit board (120).

3. The SMT panel frame (100) as claimed in Claim 1, wherein the at least one copper material region (130) is selectively etched or deposited onto the panel (110), after selectively removing copper material from the breakaway area through etching process after the lamination process, or by cutting process before the lamination process of the SMT panel frame, providing a customizable configuration based on the position and placement of Data Matrix Codes, fiducials and test points.

4. The SMT panel frame (100) as claimed in Claim 1, wherein the placement of the at least one copper material region (130) is determined based on the dimensions and form factors of the printed circuit board (120).

5. The SMT panel frame (100) as claimed in Claim 1, wherein the at least one copper material region (130) is configured to minimize the utilization of copper material on the panel surface.

6. A method for optimizing copper material on an SMT panel frame used in printed circuit board (PCB) manufacturing, the method comprising the steps of:
providing an SMT panel frame with a breakaway area on the panel, wherein copper material is selectively excluded, except in regions containing DMC, Fiducials, and test points.
implementing a copper removal process in the breakaway area of the SMT panel frame, the process comprising:
removing copper material from the breakaway area through an etching process after the lamination of the SMT panel frame or removing copper material from the breakaway area by cutting before the lamination process of the SMT panel frame.

7. The method as claimed in claim 6, wherein removing copper material from the breakaway area through an etching process after the lamination of the SMT panel frame comprising the steps of:
providing a panel with breakaway area to securely hold at least one printed circuit board (PCB);
removably arranging the panel around the printed circuit board;
selectively removing unwanted copper material from the breakaway area and retaining at least one copper material region within the breakaway area of the panel based on the placement of Data Matrix Codes (DMC), fiducials, and test points on the printed circuit boards;
customizing and aligning the arrangement of the at least one copper material region through selective etching or deposition onto the breakaway area of the panel, providing a flexible configuration based on the position and placement of Data Matrix Codes, fiducials, and test points on the printed circuit board thereby facilitating conductivity for electrical components on the printed circuit board; and
configuring the at least one copper material region to minimize the utilization of copper material on the panel surface.

8. The method as claimed in claim 7, wherein the etching process comprises selectively removing copper material from the breakaway area through chemical etching after the lamination process.

9. The method as claimed in claim 6, wherein removing copper material from the breakaway area by cutting before the lamination process of the SMT panel frame comprising the steps of:
implementing a cutting process on a copper base plate before lamination process to remove unnecessary copper and ensuring the remaining copper is sufficient for the lamination process on a PCB core material or prepreg;
retaining a defined amount of copper material on four corners of the copper base plate for pre-positioning the copper sheet before lamination, and for the placement of DMC, fiducials, test points, etc.; and
ensuring the necessary copper material is connected and not isolated, to facilitate lamination process.

10. The method as claimed in claim 9, wherein the cutting before lamination process comprises removing excess copper material from the breakaway area through a cutting process before the lamination of the SMT panel frame.
